# FASCICULE DE BREVET EUROPEEN

(11) **EP 0 358 569 B1**
(45) Date de publication et mention de la délivrance du brevet: **25.10.1995**
(21) Numéro de dépôt: 89402423.1
(22) Date de dépôt: 06.09.1989
(51) Int. Cl.: H01L 33/00, H01S 3/19

(54) **Procédé de réalisation d'un laser à semiconducteur à forte puissance d'émission et à grande bande passante à partir d'une structure à ruban enterré du type BRS**
Herstellungsverfahren für einen Halbleiterlaser mit hoher Ausgangsleistung, breiter Bandpasscharakteristik und einer vergrabenen, streifenförmigen BRS-Struktur
Method of producing a semiconductor laser with a high output power, a broad pass-band and a buried strip-like BRS structure

(30) Priorité: 08.09.1988 FR 8811744
(43) Date de publication de la demande: 14.03.1990
(73) Titulaire: FRANCE TELECOM, 75015 Paris (FR)
(72) Inventeur: Devoldere, Pascal, F-22300 Lannion (FR); Paraskevopoulos, Alkis, 1000 Berlin 36 (DE)
(74) Mandataire: Martin, Jean-Jacques

(56) Documents cités:
- EP-A- 0 273 730
- US-A- 4 523 961
- NEUES AUS DER TECHNIK, vol. 20, no. 1, février 1987, page 6, résumé no. 178, Vogel-Verlag, Würzburg DE; "Eisenimplanierter DCPBH-Laser"
- APPLIED PHYSICS LETTERS, vol. 44, no. 3, 1 février 1984, pages 290-292, American Institute of Physics, New York US; D.P. WILT et al.: "Channeled substrate buried heterostructure InGaAsP/InP laser employing a buried Fe ion implant for current confinement"

## Description

La présente invention concerne le domaine des sources lasers à semiconducteur.

Elle a pour objet principal un procédé de réalisation d'un laser à semiconducteur à forte puissance d'émission et à grande bande passante, à partir d'une structure dite à ruban enterré du type BRS (Buried Ridge Stripe).

La présente invention peut trouver tout particulièrement application en télécommunication optique, par fibres optiques, à haut débit et à longue distance, notamment sur fibre monomode à 1,3 ou 1,55 µm.

On a déjà proposé de nombreuses structures laser à ruban enterré.

Dans ces structures, la partie active du laser est un petit ruban rectangulaire en matériau InGaAsP où sont confinés à la fois les porteurs injectés et le rayonnement laser. La section du ruban de InGaAsP est typiquement de l'ordre de 0,2 x 2µm².

Le problème général posé est d'obtenir une localisation efficace du courant à partir des contacts métalliques vers le ruban enterré.

Les structures laser connues à ruban enterré peuvent être classées en deux catégories suivant la technique de localisation du courant utilisée.

Selon une première catégorie, la localisation du courant est obtenue à l'aide d'un empilement de couches d'InP alternativement de type n et de type p de part et d'autre du ruban enterré, destiné à bloquer le passage du courant dans ces régions.

L'état de la technique correspondant à cette catégorie de lasers a été assez largement décrit dans le document FR-A-2 581 801.

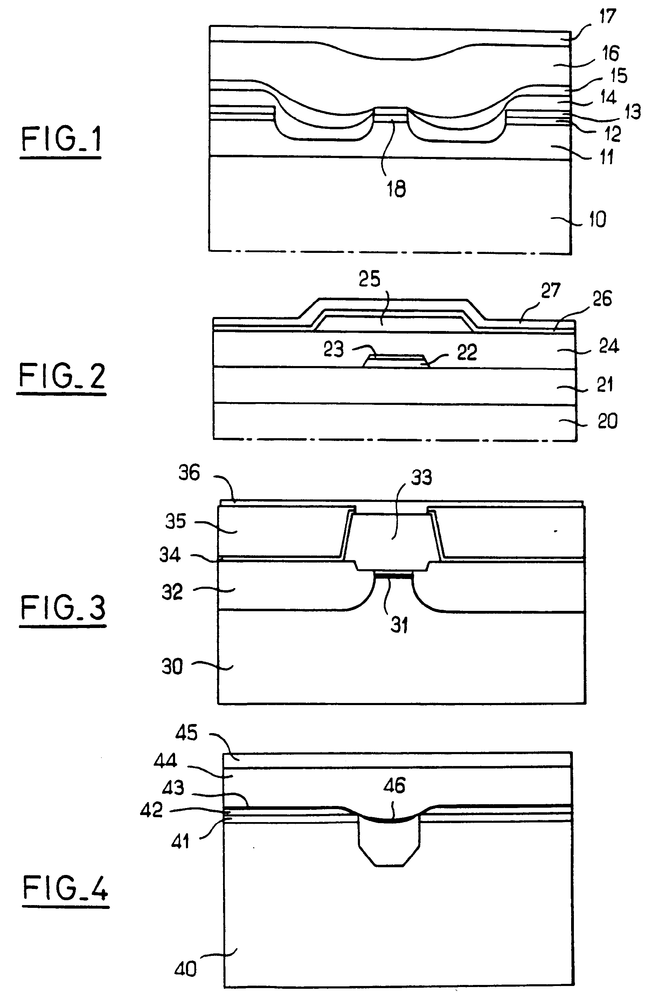

On a illustré sur la figure 1 annexée une structure typique de cet état de la technique. Cette structure est appelée DCPBH (pour Double Channel Planar Buried Heterostructure). Elle est décrite par I. MITO et al dans le document Elect. Letters, vol. 18, no 22, (1982), p 953.

La structure connue illustrée sur la figure 1 annexée comprend les couches suivantes :
- 10 : substrat en InP de type n+,
- 11 : couche de confinement en InP de type n,
- 12 : couche de InGaAsP,
- 13 : couche de confinement en InP de type p,
- 14 : couche bloquante en InP de type p,
- 15 : couche bloquante en InP de type n,
- 16 : couche de confinement en InP de type p,
- 17 : couche de contact en InGaAsP de type p+.

Sur la figure 1, la région active en InGaAsP est référencée 18.

La structure illustrée sur la figure 1 est réalisée selon le processus suivant.

Une double hétérostructure classique correspondant aux couches 11, 12 et 13 en InP de type n, en InGaAsP et en InP de type p, est réalisée en cours d'une première épitaxie, sur le substrat 10.

Des rubans ayant la forme de mésas, et correspondant à la région active 18 en InGaAsP recouverte par la couche de confinement 13 en InP de type p sont ensuite définis dans cette double hétérostructure.

Les quatre couches 14, 15, 16 et 17 en InP de type p, InP de type n, InP de type p et InGaAsP de type p+ sont ensuite réalisées au cours d'une seconde épitaxie, les couches 14 et 15 au moins étant réalisées par épitaxie en phase liquide.

Le confinement électrique est dû à l'empilement des couches 11, 14, 15, 16 : n - p - n -p.

On obtient avec les structures laser du type illustré sur la figure 1 annexée, un courant de seuil voisin de 10mA et une puissance optique émise supérieure à 50mW.

Malheureusement, ces structures connues du type illustré sur la figure 1, possèdent une bande passante faible (2 à 3 GHz). La bande passante est limitée par les capacités parasites que constituent les jonctions InP du type p et n de blocage du courant.

Pour tenter d'améliorer cette bande passante, K. KIHARA et al ont proposé dans le document Elect. Letters, vol 23, no 18 (1987), p 942, d'isoler la partie centrale du laser du reste de la puce par des gravures profondes de part et d'autre du ruban enterré, très près de celui-ci. Cette solution exige cependant la mise en oeuvre d'une technologie compliquée.

On notera que la plupart des structures du type illustré sur la figure 1 annexée sont réalisées en deux cycles d'épitaxie, voire 3 pour certaines d'entre elles, et que la seconde épitaxie est presque systématiquement une épitaxie en phase liquide pour planariser la surface.

On a illustré sur la figure 2 annexée, un autre type de structure connue qui peut être classée dans la première catégorie précitée. La structure illustrée sur la figure 2 annexée est décrite et représentée sur la figure 2 dans le document FR-A-2 587 852. Cette structure est appelée SBH (pour Strip Buried Heterostructure) dans le document précité, mais est plus communément appelée BRS (Buried Ridge Stripe) dans la littérature. Elle comprend les couches suivantes :
- 20 : substrat en InP de type n+,
- 21 : couche de confinement en InP de type n,
- 22 : couche de InGaAsP,
- 23 : couche de guidage en InGaAsP ou de protection en InPp,
- 24 : couche de InP dopé p,
- 25 : couche de GaInAs,
- 26 : couche de titane,
- 27 : couche d'or.

Elle est réalisée selon le processus suivant.

Les couches 21, 22, 23 en InP et InGaAsP sont réalisées au cours d'une première épitaxie sur le substrat 20.

Les couches 22 de InGaAsP et 23 de InGaAsP ou InP sont ensuite gravées en forme de ruban, par attaque sélective.

Puis les couches 24 et 25 de InP dopé p et de GaInAs sont réalisées au cours d'une seconde épitaxie.

Dans cette structure le confinement électrique est assuré par une seule jonction p-n dans le matériau InP, polarisée en direct et située de part et d'autre de la région active. Cette jonction p-n est formée par les couches 21 et 24. Le confinement est assuré par la différence positive entre le potentiel de diffusion d'une homojonction InP p-n et celui de l'hétérojonction laser InP n/InGaAsP p.

Cette structure permet d'obtenir un faible courant de seuil de l'ordre de 10 à 15 mA, mais une puissance optique émise limitée à 10 mW (pour une longueur d'onde d'émission de 1,3 µm). En effet, au-delà d'un certain courant (typiquement 3 à 4 fois le courant de seuil) les homojonctions InP p-n latérales deviennent conductrices car polarisées en direct au-dessus de leur potentiel de diffusion. Les mêmes jonctions constituent des capacités parasites qui limitent fortement la bande passante.

On peut tenter de limiter les capacités parasites et donc d'améliorer cette bande passante par implantation de protons dans les régions latérales au ruban enterré des couches 24, 26, 27, au plus près du ruban. Dans ces conditions, la bande passante peut atteindre 7 à 8 GHz. L'implantation de protons exige cependant, là encore, la mise en oeuvre d'une technologie assez compliquée. Par ailleurs, même après une telle implantation, il reste une région non implantée de part et d'autre du ruban enterré (largeur d'environ 2 µm de chaque côté) à l'origine de courants de fuite au-delà de 3 à 4 fois le courant de seuil.

Selon une deuxième catégorie, la localisation du courant est assurée par la présence de couches semi-isolantes, ou a tout le moins très résistantes, de part et d'autre du ruban.

Ces couches semi-isolantes sont le plus souvent réalisées par croissance épitaxiale en phase vapeur.

La plus performante de ces structures est celle décrite par J.E. BOWERS et al dans Elect Letters, vol 23, no 24, (1987), p 1265. Cette structure est dénommée SIPBH (pour Semi Insulating Planar Buried Heterostructure). Elle est illustrée schématiquement sur la figure 3 annexée.

La structure connue, illustrée sur la figure 3 annexée comprend les couches suivantes :
- 30 : substrat en InP de type n+,
- 31 : couche active en InGaAsp gravée en ruban,
- 32 : couche de confinement en InP semi isolant, disposée de part et d'autre de la couche active 31 ;
- 33 : couche de InP de type p gravée en ruban superposé au ruban actif 31 en InGaAsP,
- 34 : couche de SiO₂ sur la couche de confinement 32 et sur les flancs du ruban 33,
- 35 : couche de polyimide de part et d'autre du ruban 33,
- 36 : couche de recouvrement.

La struture illustrée sur la figure 3 annexée nécessite 3 cycles d'épitaxie et la mise en oeuvre d'une technologie assez compliquée. Cette complexité peut entraîner une mauvaise reproductibilité et réduire la fiabilité de la structure.

Cette structure connue permet d'obtenir un courant de seuil de 15 à 25 mA, une puissance émise de 20 mW et selon les auteurs du document précité, une bande passante proche de 20 GHz.

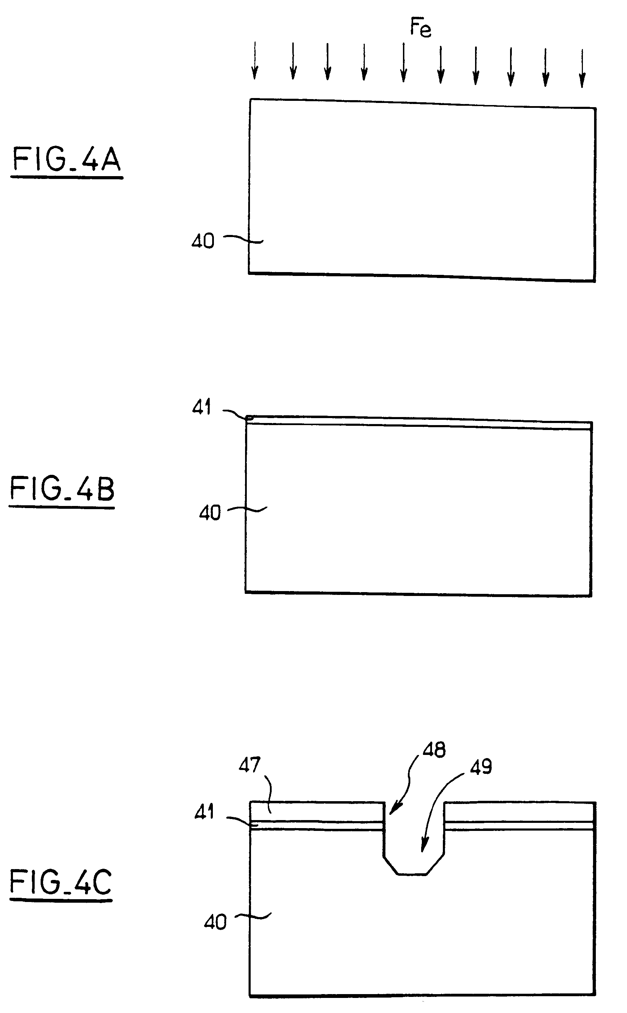

Une autre structure laser comprenant des couches semi-isolantes et répondant par conséquent à la seconde catégorie précitée, est décrite par D.P. WILT et al dans le document Appl. Phys. Lett. 44(3) 1984, p 290. Cette structure est illustrée sur la figure 4 annexée. Elle est dénommée CSBH (pour Channel Substrate Buried Heterostructure).

Selon le document précité, la couche semi-isolante est réalisée par implantation d'atomes de fer dans une couche de type n.

La structure illustrée sur la figure 4 annexée comprend les couches suivantes :
- 40 : substrat en InP de type n,
- 41 : couche de confinement de InP implantée de Fe,
- 42 : couche de InP de type n,
- 43 : couche de InGaAsP,
- 44 : couche de InP de type p,
- 45 : couche de InGaAs de type p.

Sur la figure 4, la région active en InGaAsP est référencée 46.

La structure illustrée sur la figure 4 est réalisée selon le processus suivant, représenté schématiquement sur les figures 4A, 4B et 4C.

Des ions Fe sont implantés dans le substrat InP 40 de type n (figure 4A) pour produire une couche 41, correspondant à la couche supérieure du substrat, qui présente une résistivité élevée (figure 4B).

Selon le document précité, le dopage du substrat est n = 6 x 10¹⁷ cm⁻³ et l'implantation d'ions Fe est réalisée en deux temps sous forme d'une dose de 1,25 x 10¹⁴ cm⁻² respectivement à 275 kev et 400 kev.

Un masque 47 de SiO₂ possédant des ouvertures 48 d'une largeur de 2,8 µm est placé sur la couche 41 en vue d'une gravure à l'aide de HCl : H₃PO₄.

On obtient des canaux 49 dans la couche 41 et le substrat 40. L'ensemble est recuit à 720°C pendant 15 minutes.

Puis une double hétérostructure correspondant aux couches 42, 43, 44 et 45 en InP de type n, en InGaAsP, en InP de type p et en InGaAs de type p est réalisée sur la couche 41 et le substrat 40, par épitaxie en phase liquide.

La couche 42 en InP de type n est dopée à l'étain.

La couche 43 en InGaAsP est non intentionnellement dopée.

Les couches 44 et 45 en InP de type p et en InGaAs de type p sont dopées en zinc.

Des couches métalliques de contact (AuZnAu, AuSn et TiPtAu) sont ensuite déposées.

Comme le montre la figure 1 du document précité, page 291, la région active 46 en InGaAsP réalisée sur la couche 42 en InP de type n a la forme générale d'un croissant.

Le passage du courant est théoriquement bloqué par les empilements des couches 40, 41 et 42 en InP de type n - InP semi-isolant - InP de type n formés de part et d'autre de la région active 46.

Les performances obtenues avec cette structure sont cependant moyennes : courant de seuil 22 mA, puissance optique 12 mW.

Ces performances moyennes montrent que des courants de fuite subsistent de part et d'autre de la région active 46, là où les empilements InP de type n - InP semi-isolant - InP de type n sont quasi inexistants.

Comme indiqué précédemment, les structures laser à ruban enterré ne donnent donc pas entière satisfaction.

Les inconvénients de la technique antérieure peuvent être résumés comme suit.

Les structures de la première catégorie de type DCPBH (localisation du courant par empilement de couches InP p-n-p-n) souffrent de deux inconvénients majeurs : d'une part, leur fabrication nécessite l'utilisation de l'épitaxie en phase liquide, elles ne peuvent donc bénéficier des atouts de technique de croissance plus récentes comme la MOVPE (Metal Organic Vapor Phase Epitaxy), d'autre part, leurs performances en modulation sont médiocres et ne peuvent être améliorées qu'au prix d'une technologie complexe [cf Elect. Letters vol 23, n. 18 (1987)].

La structure de type SBH répondant également à la première catégorie souffre de l'inefficacité de la jonction InP p-n pour bloquer le contact au delà d'une certaine polarisation correspondant à 2 ou 4 fois le courant de seuil. Sa bande passante est également limitée par les capacités parasites.

Les structures de la deuxième catégorie ont pour la plupart de bonnes performances mais au prix d'une technologie complexe, entre autres 3 étapes d'épitaxie sont nécessaires. Cette complexité peut entraîner une mauvaise reproductibilité de leurs caractéristiques et réduire leur fiabilité.

La dernière structure (CSBH) a l'inconvénient de ne pouvoir être réalisée que par épitaxie en phase liquide. De plus, ses performances moyennes montrent que des courants de fuite subsistent de part et d'autre de la région active, là où les compléments InP de type n - InP semi-isolant - InP de type n sont inexistants.

Le document "Neues aus der Technik, vol. 20, n° 1, Février 1987, page 6, résumé n° 185" décrit un procédé de réalisation de laser à semiconducteur à ruban enterré comprenant les étapes qui consistent à :
- déposer par épitaxie une hétérostructure comprenant une couche de matériau actif en InGaAsP encadré de deux couches InP dopées respectivement n et p, sur un substrat en InP dopé n, avec superposition d'une couche de protection en InGaAsP,
- graver cette structure pour obtenir des rubans dans la couche de matériau actif et les couches déposées préalablement par épitaxie sur celles-ci,
- éliminer la couche de protection en InGaAsP sur l'extérieur des rubans formés dans la couche de matériau actif, puis opérer une implantation ionique d'impureté Fe+ dans la structure.

Au cours de cette dernière opération, les rubans de matériau actif en InGaAsP et la couche pInP superposée sont protégés par la couche de protection supérieure en InGaAsP.

La couche de protection supérieure en InGaAsP est ensuite éliminée.

Puis une seconde épitaxie à base d'InP et d'InGaAsP est réalisée pour obtenir les couches usuelles d'isolation et de contact.

La présente invention a pour but d'améliorer sensiblement l'injection des porteurs et leur confinement latéral dans le ruban enterré en supprimant les jonctions latérales InP de type p - InP de type n polarisées en direct afin de supprimer l'effet de "shunt" de ces jonctions tant en régime continu qu'en régime de modulation sans introduire d'empilements InP p-n-p-n qui génèrent des capacités parasites élevées et donc limitent la bande de modulation.

On sait en effet que les courants de seuil, la puissance optique et la largeur de bande de modulation dépendent directement de l'efficacité de la localisation du courant.

Un autre but auxiliaire de la présente invention est de proposer un procédé de fabrication de structure laser à ruban enterré qui ne requiert qu'un nombre d'épitaxies limité à 2.

Ces buts sont atteints dans le cadre de la présente invention grâce à un procédé du type défini en revendication 1 annexée dont le préambule est défini en référence au document "Neues aus der Technik" précité.

La réalisation de l'implantation ionique d'impureté après la gravure du ruban en matériau actif, permet d'obtenir un meilleur autoalignement des couches de confinement sur les flancs du ruban que selon la technique antérieure évoquée dans le document précité Appl. Phys. Lett 44(3) 1984, p 290, qui préconise de réaliser l'implantation ionique avant dépôt du matériau actif par épitaxie.

Selon l'invention, I'impureté implantée est de préférence Fe.

La mise en oeuvre d'une couche de matériau dopé n⁻, de dopage relativement faible, spécialement adaptée à l'implantation des impuretés permet d'utiliser un substrat plus fortement dopé que selon la technique antérieure évoquée dans le document précité Appl. Phys. Lett. 44(3), 1984, p 290.

D'autres caractéristiques, buts et avantages de la présente invention apparaîtront à la lecture de la description détaillée qui va suivre et en regard des dessins annexés, donnés à titre d'exemple non limitatif et sur lesquels, les figures 1, 2, 3, 4, 4A, 4B, 4C qui illustrent l'état de la technique ayant déjà été decrites ; les figures 5A à 5E illustrent 5 étapes successives du procédé conforme à la présente invention.

Le procédé conforme à la présente invention met en oeuvre 2 épitaxies. Celles-ci peuvent être obtenues avec l'une quelconque des techniques existantes : LPE (Liquid Phase Epitaxy), MOVPE (Metal Organic Vapor Phase Epitaxy) et MBE (Molecular Beam Epitaxy).

La première épitaxie illustrée schématiquement sur la figure 5A consiste en la croissance de 4 couches 51, 52, 53, 54, sur un substrat 50.

Le substrat 50 est avantageusement en InP de type n fortement dopé. Le dopage du substrat peut être typiquement de l'ordre de 6 x 10¹⁸cm⁻³.

La première couche 51 est une couche tampon d'InP de type n+. Son dopage est avantageusement de l'ordre de 1 à 3 x 10¹⁸ cm⁻³. Son épaisseur est typiquement de l'ordre de 2µm.

La couche 52 constitue l'une des caractéristiques importantes de l'invention. Elle est formée d'InP de type n⁻ assez faiblement dopée. Son dopage est avantageusement de l'ordre de 1 à 5 x 10¹⁷ cm⁻³. Son épaisseur est typiquement de l'ordre de 0,5µm. La couche 52 peut cependant être plus épaisse. Son épaisseur dépend en fait de la profondeur d'implantation d'impureté Fe qu'elle subit ultérieurement. L'épaisseur de la couche 52 doit être à peu près égale à la profondeur d'implantation d'impureté Fe.

La couche 53 est formée du matériau actif en InGaAsP non dopé ou dopé n. Son épaisseur est typiquement de l'ordre de 0,15µm.

La couche 54 est une couche d'InP de type p. Le dopage de la couche 54 est avantageusement de l'ordre de 3 à 4 x 10¹⁷ cm⁻³. Son épaisseur est typiquement de l'ordre de 0,2µm.

Après la première épitaxie, un ruban étroit est gravé dans les deux couches supérieures 53 et 54 en InGaAsP et InP de type p.

La largeur des rubans gravés est typiquement de 2 µm.

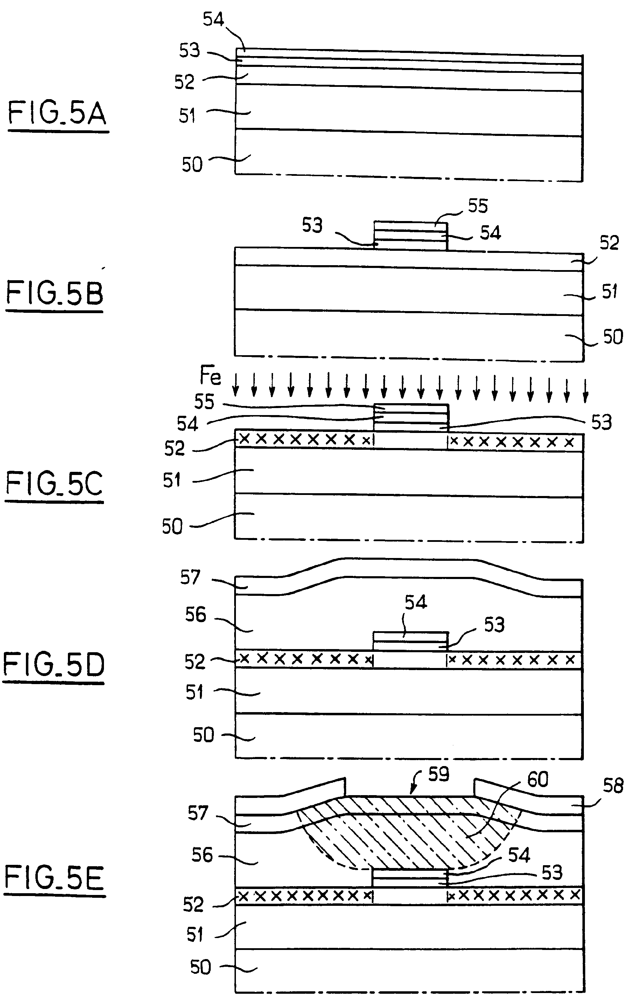

Comme illustré sur la figure 5B, pour la gravure on utilise un masque 55 par exemple un diélectrique de type Si₃N₄.

L'épaisseur e du masque doit être suffisante pour empêcher les ions Fer implantés ultérieurement, de pénétrer dans la couche 54 sous-jacente en InP p.

On procède ensuite, comme illustré schématiquement sur la figure 5C, à l'implantation de Fer sur l'ensemble de la structure ; cette implantation est réalisée en conservant en place, le masque 55 utilisé préalablement pour la gravure du ruban.

L'implantation de Fer a pour effet de rendre semi-isolante la couche 52 en InP de type n⁻, de part et d'autre du ruban et ce, de façon autoalignée, c'est-à-dire au plus près des bords du ruban. L'implantation de fer dans la couche 52 est schématisée par des croix sur les figures annexées.

A titre d'exemple, les conditions d'implantation peuvent être les suivantes : énergie 400 kev, dose 10¹³ atomes/cm², température 200°C.

De préférence l'implantation de fer est suivie d'une opération de recuit, par exemple 15 mm à 700° C.

On procède ensuite à une seconde épitaxie.

Celle-ci permet la croissance de deux couches 56, 57, schématiquement sur la figure 5D.

La première couche 56 est une couche d'InP non intentionnellement dopée. Le dopage résiduel obtenu sera typiquement n⁻≃5. 10¹⁵ cm⁻³. L'épaisseur de la couche 56 est typiquement de 1 à 1,5 µm.

La deuxième couche 57 est une couche en InGaAs non dopée. Le dopage résiduel obtenu sera typiquement n⁻≃5.10¹³ cm⁻³. Son épaisseur typique est de l'ordre de 0,5 µm.

Après la seconde épitaxie, on opère une diffusion localisée d'un dopant de type p, en l'espèce de préférence de zinc. Cette diffusion de zinc est réalisée à travers un masque 58, avantageusement en Si₃N₄, déposé sur la couche 57. Le masque 58 possède une ouverture 59. Celle-ci doit être superposée au ruban gravé (couches 53 et 54).

Sur la figure 5E, on a schématisé en traits interrompus la zone 60 d'implantation de zinc.

La diffusion du zinc est contrôlée de telle sorte que cette zone 60 vienne contacter la couche 54 en InP de type p située juste au-dessus du ruban enterré 53 en InGaAsP.

On obtient ainsi un laser à semi-conducteur et à ruban enterré dans lequel la région active 53 est entourée de part et d'autre d'InP semi-isolant 52 obtenue par implantation de Fer. L'implantation de Fer dans la couche 52 étant réalisée après la gravure de la région active ou garantit un autoalignement du matériau semi-isolant sur la régions active 53. Le matériau InP semi-isolant est pris en sandwich entre 2 couches d'InP faiblement dopées n (base de 52 et 56). Cet empilement : InPn⁻ (n ≃ 1 à 3.10¹⁷ cm⁻³)/InP semi-isolant/InPn⁻ ( n ≃ 5.10¹⁵ cm⁻³) assure un confinement très efficace sous polarisation directe de la diode jusqu'à 4V. De plus, la capacité parasite introduite par cette structure InPn⁻/InP semi-isolant/InPn⁻ est faible. Ceci permet d'obtenir une bande de modulation élevée.

Par rapport à la technique antérieure, la structure laser obtenue par le procédé conforme à la présente invention présente en outre les avantages suivants.

Selon le procédé décrit dans Appl. Phys. Lett. 44(3) 1984 p 290, l'implantation de fer est effectuée directement dans le substrat InP. Le dopage de type n de ce substrat doit donc être le plus faible possible pour que cette implantation soit efficace. Il en résulte inévitablement une augmentation de la résistance d'accès entre le contact métallique de type n et la région active du laser. Selon le document précité, le dopage du substrat est n ≃ 6 x 10¹⁷ cm⁻³.

Par contre, selon l'invention, il est prévu une couche 52 de type n spécialement adaptée à l'implantation de Fer. Ceci permet de choisir un dopage faible pour la couche implantée (n ≲ 5.10¹⁷ cm⁻³) tout en conservant un substrat 50 fortement dopé n (n≃ 6.10¹⁸ cm⁻³). Il est à noter que la réalisation de cette couche spécifique d'implantation 52 n'entraîne pas de cycle d'épitaxie supplémentaire.

L'utilisation d'une couche 56 non intentionnellement dopée permet d'optimiser l'efficacité du blocage.

## Revendications

1. Procédé de réalisation de laser à semiconducteur à ruban enterré comprenant les étapes qui consistent à :
- déposer par épitaxie au moins une hétérostructure (51, 52, 53, 54) comprenant au moins une couche de matériau actif (53), sur un substrat (50), puis
- former un masque (55) sur la structure ainsi obtenue, et
- graver celle-ci à travers le masque (55) pour obtenir des rubans dans la couche de matériau actif (53) et la ou les couche(s) (54) éventuellement déposée(s) préalablement par épitaxie sur la couche de matériau actif (53), puis
- opérer une implantation ionique d'impureté dans la structure, en protégeant les rubans de matériau actif (53) et la ou les couche(s) (54) éventuellement déposées sur ce matériau à l'aide d'un masque (55) non transparent à l'implantation ionique pour rendre semi-isolant le matériau encadrant le ruban actif enterré, caractérisé par le fait que le masque (55) utilisé lors de l'étape d'implantation ionique d'impureté est le masque déposé et utilisé pour l'opération de gravure, ce masque étant diélectrique, et une couche (52) de matériau dopé n-, avec un dopage relativement faible, est déposée avant la couche de matériau actif (53), de sorte que l'implantation ionique d'impureté est opérée dans cette couche de matériau dopé (52) n-.

2. Procédé selon la revendication 1, caractérisé par le fait que l'impureté implantée est Fe.

3. Procédé selon l'une des revendications 1 ou 2, caractérisé par le fait que la couche de matériau (52) dopé n- est de l'InP.

4. Procédé selon l'une des revendications 1 à 3, caractérisé par le fait que le dopage de la couche de matériau dopé (52) n- est de l'ordre de 1 à 5 x 10¹⁷ cm⁻³.

5. Procédé selon l'une des revendications 1 à 4, caractérisé par le fait que l'épaisseur de la couche de matériau dopé (52) n- est au minimum de 0,5 µm.

6. Procédé selon l'une des revendications 1 à 5, caractérisé par le fait qu'une couche tampon (51) de matériau dopé n+ est déposée avant la couche de matériau (52) dopé n-.

7. Procédé selon la revendication 6, caractérisé par le fait que le matériau (51) dopé n+ est de l'InP.

8. Procédé selon l'une des revendications 6 et 7, caractérisé par le fait que le dopage de la couche (51) de matériau dopé n+ est de l'ordre de 1 à 3 x 10¹⁸cm⁻³.

9. Procédé selon l'une des revendications 6 à 8, caractérisé par le fait que l'épaisseur de la couche (51) de matériau dopé n+ est de l'ordre de 2µm.

10. Procédé selon l'une des revendications 1 à 9, caractérisé par le fait que le matériau actif (53) déposé est de l'InGaAsP.

11. Procédé selon l'une des revendications 1 à 10, caractérisé par le fait que la couche de matériau actif (53) à une épaisseur de l'ordre de 0,15µm.

12. Procédé selon l'une des revendications 1 à 11, caractérisé par le fait qu'une couche (54) de matériau dopé p est déposée après la couche de matériau actif (53).

13. Procédé selon la revendication 12, caractérisé par le fait que le matériau dopé p (54) est de l'InP.

14. Procédé selon l'une des revendications 12 et 13, caractérisé par le fait que le dopage du matériau p (54) est de l'ordre de 3 à 4 x 10¹⁷ cm⁻³.

15. Procédé selon lune des revendications 12 à 14, caractérisé par le fait que l'épaisseur du matériau dopé p (54) est de l'ordre de 0,2 µm.

16. Procédé selon l'une des revendications 1 à 15, caractérisé par le fait que l'implantation ionique d'impureté est opérée à une dose de l'ordre de 10¹³ atomes/cm².

17. Procédé selon l'une des revendications 1 à 16, caractérisé par le fait que l'implantation ionique d'impureté est suivie d'une étape de recuit.

18. Procédé selon l'une des revendications 1 à 17, caractérisé par le fait que l'implantation d'impureté est suivie d'une étape consistant à réaliser une seconde épitaxie (56, 57).

19. Procédé selon la revendication 18, caractérisé par le fait qu'une couche d'InP (56) non intentionnellement dopée est déposée à l'étape de seconde épitaxie.

20. Procédé selon la revendication 19, caractérisé par le fait qu'une couche (57) en InGaAs non dopée est déposée sur la couche (56) d'InP non intentionnellement dopée.

21. Procédé selon l'une des revendications 1 à 20, caractérisé par le fait qu'il comprend l'étape ultime de diffusion localisée d'un dopant (60) de type p au-dessus des rubans enterrés (53, 54).

22. Procédé selon la revendication 21, caractérisé par le fait que le dopant (60) de type p est du zinc.

23. Procédé selon la revendications 21 ou 22 prise en combinaison avec l'une des revendications 12 à 15, caractérisé par le fait que la diffusion localisée de dopant (60) de type p contacte la couche de matériau dopé p (54) déposée par la première épitaxie.

## Patentansprüche

1. Verfahren zum Herstellen eines Halbleiterlasers mit einem vergrabenen Streifen, welches die folgenden Schritte umfaßt:
- Aufbringen mindestens einer Heterostruktur (51, 52, 53, 54), die zumindest eine Schicht aus einem aktiven Material (53) enthält, auf einem Substrat (50) durch Epitaxie, sodann
- Bilden einer Maske (55) auf der solchermaßen gewonnenen Struktur und
- Ätzen derselben durch die Maske (55) hindurch, um Streifen in der Schicht aus aktivem Material (53) und der oder den Schichten (54) zu gewinnen, die gegebenenfalls vorher durch die Epitaxie auf die Schicht aus aktivem Material (53) aufgebracht wurde(n), sodann
- Bewirken einer Fremdatom-Ionenimplantation in der Struktur, wobei die Streifen aus aktivem Material (53) und die Schicht oder die Schichten (54), welche gegebenenfalls auf diesem Material abgeschieden worden sind, mit Hilfe einer Maske (55) geschützt werden, die für die Ionenimplantation nicht durchlässig ist, um das den aktiven vergrabenen Streifen umgebende Material semiisolierend zu machen,
dadurch gekennzeichnet,
daß die bei dem Schritt der Fremdatom-Ionenimplantation verwendete Maske (55) die Maske ist, welche zum Bewirken des Ätzvorgangs aufgebracht und verwendet wurde, wobei diese Maske dielektrisch ist,
und eine Schicht (52) aus einem n-dotierten Material mit einer relativ geringen Dotierung vor der Schicht aus aktivem Material (53) derart aufgebracht wird, daß die Fremdatom-Ionenimplantation in dieser Schicht aus n-dotiertem Material (52) bewirkt wird.

2. Verfahren nach Anspruch 1, dadurch gekennzeichnet daß das implantierte Fremdatom Fe ist.

3. Verfahren nach einem der Ansprüche 1 oder 2, dadurch gekennzeichnet, daß die Schicht aus n-dotiertem Material (52) aus InP besteht.

4. Verfahren nach einem der Ansprüche 1 bis 3, dadurch gekennzeichnet, daß die Dotierung der Schicht aus n-dotiertem Material (52) ungefähr 1 bis 5·10¹⁷ cm⁻³ beträgt.

5. Verfahren nach einem der Ansprüche 1 bis 4, dadurch gekennzeichnet, daß die Dicke der Schicht aus n-dotiertem Material (52) mindestens 0,5 µm beträgt.

6. Verfahren nach einem der Ansprüche 1 bis 5, dadurch gekennzeichnet, daß eine Pufferschicht (51) aus einem n⁺-dotierten Material vor der Schicht aus einem n-dotierten Material (52) aufgebracht wird.

7. Verfahren nach Anspruch 6, dadurch gekennzeichnet, daß das n⁺-dotierte Material (51) aus InP besteht.

8. Verfahren nach einem der Ansprüche 6 und 7, dadurch gekennzeichnet, daß die Dotierung der Schicht aus n⁺-dotiertem Material (51) ungefähr 1 bis 3 · 10¹⁸cm⁻³ beträgt.

9. Verfahren nach einem der Ansprüche 6 bis 8, dadurch gekennzeichnet, daß die Dicke der Schicht aus einem n⁺-dotierten Material (51) ungefähr 2 µm beträgt.

10. Verfahren nach einem der Ansprüche 1 bis 9, dadurch gekennzeichnet, daß das aufgebrachte aktive Material (53) aus InGaAsP besteht.

11. Verfahren nach einem der Ansprüche 1 bis 10, dadurch gekennzeichnet, daß die Schicht aus aktivem Material (53) eine Dicke von ungefähr 0,15 µm aufweist.

12. Verfahren nach einem der Ansprüche 1 bis 11, dadurch gekennzeichnet, daß eine Schicht aus p-dotiertem Material (54) nach der Schicht aus aktivem Material (53) aufgebracht wird.

13. Verfahren nach Anspruch 12, dadurch gekennzeichnet, daß das p-dotierte Material (54) aus InP besteht.

14. Verfahren nach einem der Ansprüche 12 und 13, dadurch gekennzeichnet, daß die Dotierung des p-dotierten Materials (54) ungefähr 3 bis 4 · 10¹⁷ cm⁻³ beträgt.

15. Verfahren nach einem der Ansprüche 12 bis 14, dadurch gekennzeichnet, daß die Dicke des p-dotierten Materials (54) ungefähr 0,2 µm beträgt.

16. Verfahren nach einem der Ansprüche 1 bis 15, dadurch gekennzeichnet, daß die Fremdatom-Ionenimplantation bei einer Dosis von ungefähr 10¹³ Atomen/cm² bewirkt wird.

17. Verfahren nach einem der Ansprüche 1 bis 16, dadurch gekennzeichnet, daß der Fremdatom-Ionenimplantation ein Temperschritt folgt.

18. Verfahren nach einem der Ansprüche 1 bis 17, dadurch gekennzeichnet, daß der Fremdatomimplantation ein Schritt folgt, der im Realisieren einer zweiten Epitaxie (56, 57) besteht.

19. Verfahren nach Anspruch 18, dadurch gekennzeichnet, daß eine InP-Schicht (56), welche nicht vorsätzlich dotiert ist, bei dem Schritt der zweiten Epitaxie aufgebracht wird.

20. Verfahren nach Anspruch 19, dadurch gekennzeichnet, daß eine Schicht (57) aus nicht dotiertem InGaAs auf der nicht vorsätzlich dotierten InP-Schicht (56) aufgebracht wird.

21. Verfahren nach einem der Ansprüche 1 bis 20, dadurch gekennzeichnet, daß es den letzten Schritt einer lokalisierten Diffusion einer Dotierungssubstanz (60) vom Typ p oberhalb der vergrabenen Streifen (53, 54) umfaßt.

22. Verfahren nach Anspruch 21, dadurch gekennzeichnet, daß die Dotierungssubstanz (60) vom Typ p aus Zink besteht.

23. Verfahren nach einem der Ansprüche 21 oder 22 in Verbindung mit einem der Ansprüche 12 bis 15, dadurch gekennzeichnet, daß die lokalisierte Diffusion einer Dotierungssubstanz vom Typ p (60) mit der Schicht aus p-dotiertem Material (54) in Kontakt kommt, welche durch die erste Epitaxie aufgebracht wurde.

## Claims

1. Method of manufacturing a buried stripe semiconductor laser comprising the steps of:
- depositing by epitaxy at least one heterostructure (51, 52, 53, 54) comprising at least one layer (53) of active material onto a substrate (50), then
- forming a mask (55) onto the structure thus obtained, and
- etching the latter through the mask (55) to obtain stripes in the layer (53) of active material and any layer or layers (54) previously deposited by epitaxy on the active material layer (53), then
- carrying out ionic implantation of impurity into the structure, protecting the active material stripes (53) and any layer or layers (54) that may have been deposited onto this material using a mask (55) that is not transparent to ionic implantation, to render the material around the buried active stripe semi-insulative, characterised in that the mask (55) used in the impurity ionic implantation step is the mask deposited and used for the etching operation, which mask is a dielectric mask, and a relatively weakly n⁻ doped material layer (52) is deposited before the layer of active material (53) so that the impurity ionic implantation is carried out in this n doped material layer (52).

2. Method according to claim 1 characterised in that the impurity implanted is Fe.

3. Method according to claim 1 or claim 2 characterised in that the material of the n⁻ doped layer (52) is InP.

4. Method according to any one of claims 1 through 3 characterised in that the doping of the n⁻ doped material layer (52) is in the order of 1 x 10¹⁷ cm⁻³ to 5 x 10¹⁷ cm⁻³.

5. Method according to any one of claims 1 through 4 characterised in that the thickness of the n⁻ doped material layer (52) is at least 0.5 µm.

6. Method according to any one of claims 1 through 5 characterised in that a buffer layer (51) of n⁺ doped material is deposited before the layer (52) of n⁻ doped material.

7. Method according to claim 6 characterised in that n⁺ doped material (51) is InP.

8. Method according to claim 6 or claim 7 characterised in that the doping of the n⁺ doped material layer (51) is in the order of 1 x 10¹⁸ cm⁻³ to 3 x 10¹⁸ cm⁻³.

9. Method according to any one of claims 6 through 8 characterised in that the thickness of the n⁺ doped material layer (51) is in the order of 2 µm.

10. Method according to any one of claims 1 through 9 characterised in that the active material (53) deposited is InGaAsP.

11. Method according to any one of claims 1 through 10 characterised in that the active material layer (53) has a thickness in the order 0.15 µm.

12. Method according to any one of claims 1 through 11 characterised in that a layer (54) of p doped material is deposited after the active material layer (53).

13. Method according to claim 12 characterised in that the p doped material (54) is InP.

14. Method according to claim 12 or claim 13 characterised in that the doping of the p material (54) is in the order of 3 x 10¹⁷ cm⁻³ to 4 x 10¹⁷ cm⁻³.

15. Method according to any one of claims 12 through 14 characterised in that the thickness of the p doped material (54) is in the order of 0.2 µm.

16. Method according to any one of claims 1 through 15 characterised in that the impurity ionic implantation is effected with a dose in the order of 10¹³ atoms/cm².

17. Method according to any one of claims 1 through 16 characterised in that the impurity ionic implantation is followed by an annealing step.

18. Method according to any one of claims 1 through 17 characterised in that the impurity implantation step is followed by a second epitaxial stage (56, 57).

19. Method according to claim 18 characterised in that an InP layer (56) that is not intentionally doped is deposited in the second epitaxial stage.

20. Method according to claim 19 characterised in that an undoped InGaAs layer (57) is deposited over the layer (56) of InP that is not intentionally doped.

21. Method according to any one of claims 1 through 20 characterised in that it comprises a final step involving localised diffusion of a p type dopant (60) over the buried stripes (53, 54).

22. Method according to claim 21 characterised in that the p type dopant (60) is zinc.

23. Method according to claim 21 or claim 22 taken in combination with any one of claims 12 through 15 characterised in that the localised diffusion of p type dopant (60) contacts the p doped material layer (54) deposited by the first epitaxy stage.
